# EUROPÄISCHE PATENTANMELDUNG

(11) **EP 3 272 902 A1**
(43) Veröffentlichungstag der Anmeldung: **24.01.2018**
(21) Anmeldenummer: 17172654.0
(22) Anmeldetag: 24.05.2017
(51) Int. Cl.: C23C 16/04, C23C 14/04, C23C 14/54, C23C 16/52

(54) **VERFAHREN UND PRÜFSYSTEM ZUM PRÜFEN VON VAKUUM-BARRIERESCHICHTEN**

(30) Priorität: 18.07.2016 DE 102016113218
(71) Anmelder: Waldorf Technik GmbH, 78234 Engen (DE)
(72) Erfinder: CZIZEGG, Wolfgang, 78256 Steisslingen (DE)
(74) Vertreter: Patentanwälte Behrmann Wagner PartG mbB

(57) **Zusammenfassung**

Die Erfindung betrifft ein Verfahren zum Prüfen eines Vakuum-Barriereschicht-Beschichtungsergebnisses von auf das Vorliegen systematischer Fehler nach einem Vakuum-Beschichtungsvorgang, bei welchem gleichzeitig eine Vielzahl von Kunststoffteilen (3), insbesondere Verpackungsbehälter, mit einer Vakuum-Barriereschicht, insbesondere umfassend SiOₓ, beschichtet werden, in dem mehrere Träger (5, 7, 9) mit jeweils einer mehrere der Kunststoffteile (3) umfassenden Gruppe (4, 6, 8) beladen und die, bevorzugt gleich großen, Gruppen (4, 6, 8) von Kunststoffteilen (3) gleichzeitig in einer Vakuum-Beschichtungskammer (2) mit der Vakuum-Barriereschicht im Vakuum, insbesondere mittels eines ALD-Beschichtungsverfahrens und/oder eines CVD-Beschichtungsverfahrens und/oder eines PVD-Beschichtungsverfahrens beschichtet werden. Erfindungsgemäß ist vorgesehen, dass nach dem Vakuum-Beschichtungsvorgang mindestens eines der Kunststoffteile (3), bevorzugt ausschließlich eines der Kunststoffteile (3), von jeder der Gruppen (4, 6, 8) der gleichzeitig in der Vakuum-Beschichtungskammer (2) beschichteten Kunststoffteile (3) in einer Prüfeinrichtung (10) zerstörungsfrei auf das Vorliegen von Beschichtungsmängeln überprüft wird.

## Beschreibung

Die Erfindung betrifft ein Verfahren gemäß dem Oberbegriff des Anspruchs 1 zum Prüfen eines Vakuum-Barriereschicht-Beschichtungsergebnisses auf das Vorliegen systematischer, beispielsweise auf einer Fehlfunktionalität oder Fehlparametrisierung der Vakuum-Beschichtungskammer beruhender Fehler nach einem Vakuum-Beschichtungsvorgang, bei welchem gleichzeitig eine Vielzahl von Kunststoffteilen, insbesondere Verpackungsbehälter, mit einer Vakuum-Barriereschicht, insbesondere umfassend SiOₓ, beschichtet werden, in dem mehrere Träger mit jeweils einer mehrere der Kunststoffteile umfassenden Gruppe beladen und die, bevorzugt gleich großen, Gruppen von Kunststoffteilen gleichzeitig in einer Vakuum-Beschichtungskammer mit der Vakuum-Barriereschicht im Vakuum, insbesondere mittels eines ALD-Beschichtungsverfahrens und/oder eines CVD-Beschichtungsverfahrens und/oder eines PVD-Beschichtungsverfahrens beschichtet werden.

Ferner betrifft die Erfindung ein Prüfsystem gemäß dem Oberbegriff des Anspruchs 7, das zur Durchführung eines erfindungsgemäßen Prüfverfahrens bestimmt und eingerichtet bzw. ausgebildet ist.

Aus der WO 2009/030425 A1 sind ein Verfahren und eine Vorrichtung zur Herstellung von Verpackungsteilen mit einer Vakuum-Barriereschicht mit guter Durchtrittswirkung gegen Wasserdampf und Gase bekannt. Dabei werden die, beispielsweise durch Spritzgießen oder Blasformen hergestellten Kunststoffverpackungsteile mittels eines Plasma-CVD-Verfahrens oder mittels eines Sputterverfahrens mit einer keramischen und/oder metallischen Vakuum-Beschichtung versehen. Bezüglich des Beschichtungsvorgangs verweist die vorgenannte Druckschrift auf die EP 1 048 746 B1. Die bekannte Vakuum-Barriereschicht weist eine hohe Durchtrittssperrwirkung gegen Wasserdampf und Gase, insbesondere Sauerstoff auf. Es besteht jedoch der Bedarf, das Beschichtungsergebnis, d.h. die Qualität bzw. Vollflächigkeit der Barriereschicht zu überprüfen. Hierzu schlägt die DE 10 2013 110 742 A1 vor, die Beschichtung eines Kunststoffteils einer Beschichtungscharge mittels eines zerstörenden Verfahrens zu überprüfen. Bei dem bekannten Verfahren wird das zu überprüfende Kunststoffformteil mit einem Prüfmedium beaufschlagt, welches so beschaffen ist, dass es nach Ablauf einer Mindesteinwirkzeit mit dem Kunststoff des Kunststoffspritzgussteils in Wechselwirkung tritt, nicht jedoch oder zumindest in einem geringeren Maß mit der Vakuum-Barriereschicht. Im Rahmen des Prüfverfahrens wird dann untersucht, ob an dem Kunststoffspritzgussteil Bereiche vorhanden sind, in denen das Prüfmedium in Wechselwirkung mit dem Kunststoff des Kunststoffteils getreten ist, wobei ein Auffinden solcher Bereiche einen Indikator für eine fehlerhafte Barriereschicht darstellt. Das bekannte Verfahren hat sich bewährt. Es besteht jedoch in mehrerer Hinsicht Verbesserungspotential. Zum einen ist nachteilig, dass die überprüften Kunststoffteile aufgrund der Kontamination mit dem Prüfmedium nicht mehr bestimmungsgemäß verwendet werden können. Darüber hinaus können systematische Beschichtungsfehler bei der vorgeschlagenen Überprüfung eines einzigen Kunststoffteils einer Beschichtungscharge nicht hinreichend sicher festgestellt werden. Eine solche Beschichtungscharge umfasst typischerweise eine Mehrzahl von Kunststoffteilgruppen, wobei jede Gruppe auf einem Träger angeordnet ist und die Träger übereinander in der Beschichtungskammer aufgenommen sind.

Ausgehend von dem vorgenannten Stand der Technik liegt der Erfindung die Aufgabe zugrunde, ein verbessertes Prüfverfahren zum Prüfen eines Vakuum-Barriereschicht-Beschichtungsergebnisses anzugeben, mit dem systematische Fehler mit erhöhter Sicherheit erkannt werden. Die überprüften Kunststoffteile sollen dabei durch die Prüfung nicht beschädigt werden, sondern wieder bestimmungsgemäß eingesetzt werden können. Ferner besteht die Aufgabe darin ein Prüfsystem zur Ausführung eines solchen verbesserten Verfahrens anzugeben.

Diese Aufgabe wird hinsichtlich des Verfahrens mit den Merkmalen des Anspruchs 1 gelöst, d.h. bei einem gattungsgemäßen Verfahren dadurch, dass nach dem Vakuum-Beschichtungsvorgang mindestens eines der Kunststoffteile (Kunststoffformteile) von jeder Gruppe, bevorzugt ausschließlich eines der Kunststoffteile (Kunststoffformteile) von jeder der Gruppen, in einer Prüfeinrichtung zerstörungsfrei auf das Vorliegen von Beschichtungsmängeln überprüft wird.

Hinsichtlich des Prüfsystems wird die Aufgabe mit den Merkmalen des Anspruchs 7 gelöst, d.h. bei einem gattungsgemäßen Prüfsystem dadurch, dass das Prüfsystem eine zerstörungsfreie arbeitende Prüfeinrichtung umfasst sowie Handhabungsmittel, die von einer Steuereinrichtung ansteuerbar sind, die die Handhabungsmittel derart ansteuernd ausgebildet ist, dass nach dem Vakuum-Beschichtungsvorgang mindestens eines der Kunststoffteile, bevorzugt ausschließlich eines der Kunststoffteile, von jeder der Gruppen der gleichzeitig in der Vakuum-Beschichtungskammer beschichteten Kunststoffteile der Prüfeinrichtung zugeführt wird, und dass die Prüfeinrichtung das jeweils zugeführte Kunststoffteil zerstörungsfrei auf das Vorliegen von Beschichtungsmängeln überprüfend ausgebildet ist.

Vorteilhafte Weiterbildungen der Erfindung sind in den Unteransprüchen angegeben. In den Rahmen der Erfindung fallen sämtliche Kombinationen aus zumindest zwei von in der Beschreibung, den Ansprüchen und/oder den Figuren offenbarten Merkmalen.

Zur Vermeidung von Wiederholungen sollen vorrichtungsgemäß offenbarte Merkmale auch als verfahrensgemäß offenbart gelten und beanspruchbar sein. Ebenso sollen verfahrensgemäß offenbarte Merkmale auch als vorrichtungsgemäß offenbart gelten und beanspruchbar sein.

Der Erfindung liegt der Gedanke zugrunde, nach einem Vakuum-Beschichtungsvorgang, der Bestandteil des erfindungsgemäßen kombinierten Prüf- und Beschichtungsverfahrens ist, von einer Beschichtungscharge mehrere Kunststoffteile zerstörungsfrei im Hinblick auf Beschichtungsmängel der zuvor aufgebrachten Vakuum-Barriereschicht, bevorzugt mit einer Durchtrittsperrwirkung gegen Wasserdampf und Sauerstoff, zu überprüfen, um somit mit erhöhter Sicherheit systematische Fehler frühzeitig erkennen zu können. Im Detail werden im Rahmen eins erfindungsgemäßen Vakuum-Beschichtungsvorgangs gleichzeitig eine Vielzahl von Kunststoffteilen (Kunststoffformteilen), insbesondere Verpackungsbehälter, insbesondere für Kosmetika, Lebensmittel und/oder Arzneimittel mit einer Vakuum-Barriereschicht, insbesondere umfassend SiOₓ in einer Vakuum-Beschichtungskammer beschichtet, wobei diese gleichzeitig zu beschichtenden Kunststoffteile auf mehrere Gruppen von Kunststoffteilen aufgeteilt wird bzw. sind, wobei jede Gruppe einem Träger zugeordnet bzw. auf einem Träger angeordnet wird und die Gruppen von Kunststoffteilen auf ihren Trägern, d.h. auf ihrem jeweiligen Täger gemeinsam in der Beschichtungskammer beschichtet werden, wobei die Träger übereinander und/oder untereinander in der Vakuum-Beschichtungskammer aufgenommen bzw. platziert werden. Bevorzugt befindet sich oberhalb jedes Trägers eine eigene Plasmaquelle zur Erzeugung eines Beschichtungsplasmas, insbesondere im Rahmen eines besonders bevorzugten ALD-Beschichtungsverfahrens. Erfindungswesentlich ist es nun, dass von jeder der Gruppen und damit von jedem der Träger eines der Kunststoffteile zerstörungsfrei auf das Vorliegen von Beschichtungsmängeln überprüft wird. Durch die zerstörungsfreie Überprüfung, beispielsweise wie später noch erläutert noch erläutert werden wird durch ein spektrales Reflexionsverfahren und/oder mittels optischer Kohärenztomographie (OCT) und/oder mittels eines fourier-transformations-infrarotspektrometrischen Verfahrens (FTIR) ist es möglich, die überprüften Kunststoffteile nach ihrer Prüfung bestimmungsgemäß weiterzuverwenden, was in Weiterbildung der Erfindung vorgesehen ist - somit muss nicht zwingend eine Aussortierung erfolgen, wie dies bei dem in der DE 10 2013 110 742 A1 beschriebenen Verfahren der Fall ist. Alternative Verfahren sind einsetzbar. Ein ganz wesentlicher Vorteil des erfindungsgemäßen Verfahrens besteht darin, dass systemische Fehler mit einer erhöhten Sicherheit erkannt werden können, da mindestens ein Kunststoffteil, vorzugsweise ausschließlich ein Kunststoffteil jeder Gruppe und somit jedes Trägers auf Beschichtungsmängel überprüft wird. Dies ist insbesondere bei einer zuvor geschilderten bevorzugten Ausgestaltung der Vakuum-Beschichtungskammer von Vorteil, bei der oberhalb jedes Trägers und somit bevorzugt oberhalb jeder entlang der Vertikalen übereinander angeordneten Beschichtungsetage eine eigene Plasmaquelle angeordnet ist bzw. ein eigenes Plasma gezündet wird, um somit die Vakuum-Barriereschicht, insbesondere eine ALD-Schicht, bevorzugt bestehend aus oder umfassend SiOₓ, im Vakuum auf die Kunststoffteile aufzubringen.

Die zuvor beschriebene Überprüfung eines Kunststoffteils jeder Gruppe einer Beschichtungscharge wird bevorzugt inline mit der vorgelagerten Vakuum-Beschichtung durchgeführt - hierzu ist die Prüfeinrichtung inline der Vakuum-Beschichtungskammer nachgeordnet und/oder in dieser angeordnet und kann mit entsprechenden Handhabungsmitteln durch deren geschickte bzw. erfindungsgemäße Ansteuerung mit jeweils einem Kunststoffteil jeder Charge beschickt werden oder eine Prüfeinheit, insbesondere ein Messkopf der Prüfeinrichtung wird mittels eines geeigneten Antriebs, beispielsweise eines Roboterarms (Handhabungsmittel) zu den, bevorzugt auf den Trägern angeordneten, zu prüfenden Kunststoffteilen verfahren (entweder noch in der Beschichtungskammer oder dieser nachgeordnet, d.h. außerhalb der Beschichtungskammer). Auf eine solche inline-Verfahrensdurchführung bzw. -Anordnung der Prüfeinrichtung ist die Erfindung jedoch nicht beschränkt. Grundsätzlich ist es auch denkbar, die Überprüfung offline bezogen auf den Beschichtungsvorgang durchzuführen, beispielsweise an einem anderen Ort - wesentlich ist lediglich, dass die Gruppenzuordnung der Kunststoffteile insoweit erhalten bleibt, als dass sichergestellt wird, dass mindestens ein Kunststoffteil, vorzugsweise ausschließlich ein Kunststoffteil jeder Gruppe eines Beschichtungsvorgangs, d.h. einer Beschichtungscharge zerstörungsfrei im Hinblick auf Beschichtungsmängel der jeweiligen Vakuum-Barriereschicht überprüft wird.

Ganz besonders bevorzugt ist eine Ausführungsvariante des Verfahrens, bei dem bei Erkennen eines Beschichtungsfehlers bei einem überprüften Kunststoffteil die gesamten Kunststoffteile der zugehörigen Gruppe aussortiert werden. Bevorzugt erfolgt diese Aussortierung vor einem ersten Verpackungsschritt nach der Beschichtung, um insofern auf einen solchen Verpackungsschritt verzichten zu können. Im Rahmen des Prüfsystems sind zum Aussortieren einer Gruppe von Kunststoffteilen entsprechende Aussortiermittel, beispielsweise Ausblasmittel, od.dgl. Einrichtungen vorgesehen.

Wie erwähnt ist es besonders bevorzugt, wenn die Prüfeinrichtung inline mit der Vakuum-Beschichtungskammer angeordnet ist, insbesondere derart, dass die Kunststoffteile vor einer Weiterverarbeitung der zuvor beschichteten Kunststoffteile, beispielsweise durch Verpacken oder Befüllen mit einem Packgut, wie einem Lebensmittel, einem Arzneimittel oder Kosmetika im Hinblick auf die Vakuum-Beschichtungsfehler überprüfbar sind. Alternativ ist es denkbar, die Prüfeinrichtung offline bezogen auf die Vakuum-Beschichtungskammer anzuordnen, insbesondere an einem Ort, wie einem anderen Raum oder einer anderen Fertigungsstätte, wobei die Gruppen von Kunststoffteilen unter Beibehaltung des Gruppenbezugs, insbesondere (zwischen-)verpackt zu der Prüfeinrichtung transportiert werden. Dabei ist es grundsätzlich möglich, dass die Gruppen einer Beschichtungscharge, d.h. eines gemeinsamen Beschichtungsvorgangs jeweils zusammen bzw. in einer gemeinsamen Umverpackung angeordnet werden - alternativ ist es möglich, die Gruppen nach Positionierung in der Beschichtungskammer zu sortieren, so dass jeweils die Gruppen von Kunststoffteilen, die an derselben Stelle bzw. Position in der Vakuum-Beschichtungskammer während eines jeweiligen Vakuum-Beschichtungsvorgangs angeordnet waren gemeinsam verpackt werden - dabei muss jedoch dann immer noch sichergestellt werden, dass diese sich an der gleichen Relativposition in der Beschichtungskammer bei unterschiedlichen Beschichtungsvorgängen befindlichen Gruppen trennbar bzw. identifizierbar sind, um aus jeder dieser Gruppen mindestens ein, vorzugsweise ausschließlich ein Kunststoffteil im Rahmen des erfindungsgemäßen Verfahrens im Hinblick auf Vakuum-Beschichtungsmängel überprüfen zu können.

Eine noch weiter erhöhte Sicherheit zur Erkennung systematischer Beschichtungsfehler kann in Weiterbildung des erfindungsgemäßen Verfahrens und der erfindungsgemäßen Vorrichtung dadurch erreicht werden, dass bei zwei aufeinanderfolgenden Beschichtungsvorgängen nicht die einander entsprechenden bzw. gleich auf einem Träger positionierten Kunststoffteile einer Prüfung mittels der Prüfeinrichtung unterzogen werden, sondern voneinander unterschiedliche. Bevorzugt werden nacheinander, d.h. bei aufeinanderfolgenden Beschichtungsvorgängen immer wieder unterschiedlich auf einem Träger positionierte Kunststoffteile untersucht. Anders ausgedrückt sind die Kunststoffteile eines Trägers in einer festen Relativposition zueinander, insbesondere matrixförmig, beispielsweise in Spalten und dazu rechtwinklig verlaufenden Zeilen angeordnet. Diese Relativanordnung ist von Beschichtungsvorgang zu Beschichtungsvorgang auf den jeweils an derselben Position in der Beschichtungskammer zu positionierenden Trägern gleich. In Weiterbildung der Erfindung ist nun vorgesehen, dass in mindestens zwei aufeinanderfolgenden Beschichtungsvorgängen von Trägern, die sich bei den unterschiedlichen Beschichtungsvorgängen auf derselben Position in der Beschichtungskammer befinden, Kunststoffteile von unterschiedlichen Positionen auf den Trägern der Beschichtung zugeführt werden, um somit im Laufe der Zeit möglichst viele, insbesondere sämtliche Kunststoffteilpositionen auf einem Träger im Hinblick auf Beschichtungsmängel durchprüfen zu können. Sind beispielsweise die Kunststoffteile auf dem Träger in mit Zahlen kennzeichenbaren Spalten und in senkrecht dazu angeordneten, mit Buchstaben bezeichenbaren Zeilen angeordnet, wird beispielsweise nach einem ersten Beschichtungsvorgang von einem in der Beschichtungskammer an einer bestimmten, beispielsweise der obersten Position befindlichen Träger ein Kunststoffteil der Prüfeinrichtung zugeführt, beispielsweise das an der Position A1 befindliche Kunststoffteil. Bei dem darauffolgenden Beschichtungsvorgang wird dann von dem gleichpositionierten, also in dem Beispiel dem obersten Träger nicht das an der Position A1 angeordnete Kunststoffteil sondern ein anders positioniertes Kunststoffteil dieses Trägers, beispielsweise das an Position B5 befindliche Kunststoffteil der Prüfeinrichtung zugeführt und auf Beschichtungsmängel überprüft.

Das Merkmal, dass von jeder der Gruppen der gleichzeitig in der Vakuum-Beschichtungskammer beschichteten Kunststoffteilen der Prüfeinrichtung ein Kunststoffteil mittels Handhabungsmitteln zugeordnet wird, kann auf zwei unterschiedliche Arten realisiert sein. So ist es gemäß einer ersten Ausführungsvariante denkbar, die entsprechenden Kunststoffteile aktiv mittels geeigneter Handhabungsmittel zu verstellen, insbesondere von dem jeweiligen Träger zu entnehmen und zu einer, bevorzugt ortsfesten Prüfeinrichtung zu transportieren, wo dann die eigentliche Überprüfung stattfindet. Alternativ sind die Handhabungsmittel einer Prüfeinheit, beispielsweise einem Prüfkopf bzw. Messkopf der Prüfeinrichtung zugeordnet, der dann aktiv relativ zu den Kunststoffteilen verstellt wird, insbesondere in dem mit der Prüfeinheit entsprechende Positionen bzw. Kunststoffteile zu Überprüfungszwecken, bevorzugt auf den Trägern, angefahren werden. Das Zuordnen der zu überprüfenden Kunststoffzeile zu der Prüfeinrichtung bedeutet also die Realisierung einer Relativbewegung zwischen den zu überprüfenden Kunststoffteilen und der Prüfeinrichtung bzw. einer Prüfeinheit der Prüfeinrichtung zum Zusammenführen von Prüfeinrichtung und zu überprüfenden Kunststoffteilen, um gezielt bestimmte Kunststoffteile im Hinblick auf die Qualität von deren Barriereschicht überprüfen zu können.

Wie eingangs erwähnt ist es erfindungswesentlich, dass die Prüfung der Kunststoffteile zerstörungsfrei erfolgt, noch weiter bevorzugt auch berührungsfrei. Eine Möglichkeit zur zerstörungsfreien Prüfung, insbesondere zur punktuellen Schichtmessung steht in dem Einsatz einer Messung mittels spektraler Reflexion. Diese Methode ist empfindlich, schnell und gut auswertbar. Entsprechende Messgeräte werden beispielsweise von der Firma Filmetrics Inc. angeboten (www.filmetrics.de). Alternativ ist es denkbar die Barriereschicht mittels OCT (optischer Kohärenztomographie) zu prüfen. Entsprechende Prüfeinrichtungen bzw. Messeinrichtungen bietet die Firma Flo-ir, Oberdorf NW, CH an. Besonders bevorzugt ist die Überprüfung der Barriereschichtqualität mittels eines Fourier-Transformations-Infrarotspektrometers, beispielsweise dem Gerät Agilent 4100, ExoScan der Firma Agilent Technologies.

Weitere Vorteile, Merkmale und Einzelheiten der Erfindung ergeben sich aus der nachfolgenden Beschreibung bevorzugter Ausführungsbeispiele sowie anhand der Zeichnungen.

Diese zeigen in:
- Fig. 1:: eine schematische Darstellung eines Prüfsystems, umfassend eine Prüfeinrichtung und eine dieser vorgeordnete, Vakuum-Beschichtungskammer zum Aufbringen einer Vakuum-Barriereschicht, beispielsweise einer ALD-Schicht im Vakuum,
- Fig. 2:: einen der Träger aus Fig. 1 mit darauf matrixartig angeordneten, zu beschichtenden Kunststoffteilen, hier Verpackungsbehältern in Form von Bechern, und
- Fig. 3:: zwei mittels FTIR-Technologie aufgenommene Spektren von einem (korrekt) beschichteten Kunststoffteil und einem unbeschichteten Kunststoffteil.

In den Figuren sind gleiche Elemente und Elemente mit der gleichen Funktion mit den gleichen Bezugszeichen gekennzeichnet.

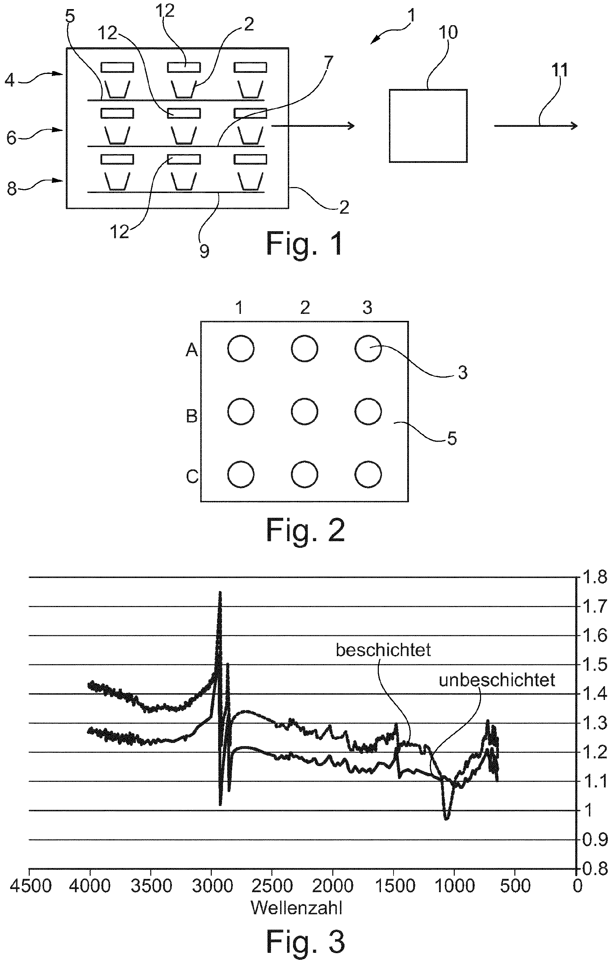

In Fig. 1 ist ein Prüfsystem 1 gezeigt, umfassend eine hier als ALD-Beschichtung ausgebildete Vakuum-Beschichtungskammer 2, in der gleichzeitig eine Vielzahl von Kunststoffteilen 3, hier als Verpackungsbehälter zur Aufnahme eines Verpackungsinhaltes in einer Kavität ausgebildete Kunststoffformteile beschichtbar sind.

Die beschichtbaren bzw. zu beschichtenden Kunststoffteile 3 sind in dem gezeigten Ausführungsbeispiel auf insgesamt drei Gruppen von Kunststoffteilen aufgeteilt, nämlich eine erste Gruppe 4, die auf einem ersten, hier oberen Träger 5 angeordnet ist, eine zweite Gruppe 6, die auf einem zweiten, hier beispielhaft mittleren Träger 7 angeordnet ist und eine dritte Gruppe 8, die auf einem dritten, hier beispielhaft unteren Träger 9 angeordnet ist.

Die Relativanordnung der Kunststoffteile 3 der verschiedenen Gruppen 4, 6, 8 auf dem jeweiligen Träger 5, 7, 9 ist gleich und beispielhaft wie in Fig. 2 dargestellt realisiert. Zu erkennen sind die matrixartig angeordneten Kunststoffteile 3, die in drei Spalten 1 bis 3 sowie drei senkrecht dazu verlaufenden Zeilen A bis C angeordnet sind.

Nach der Beschichtung werden die Gruppen 4, 6, 8, vorzugsweise zusammen mit dem jeweils zugehörigen Träger 5, 7, 9 automatisiert aus der Vakuum-Beschichtungskammer 2 entnommen, wobei mit nicht gezeigten Handhabungsmitteln, beispielsweise in Form mindestens eines Greifers oder eines Förderbandsystems von jeder der Gruppen 4, 6, 8 ein Kunststoffteil 3 in eine Prüfeinrichtung 10 überführt wird, in welcher zerstörungsfrei die zuvor aufgebrachte Vakuum-Beschichtung im Hinblick auf Beschichtungsmängel untersucht wird. In dem konkreten Ausführungsbeispiel umfasst die Prüfvorrichtung hierzu beispielhaft ohne hierauf beschränkt zu sein einen Fourier-Transformations-Infrarotsprektrometer. Für den Fall, dass der Prüfeinrichtung 10 eine fehlerhafte Beschichtung eines zu prüfenden Kunststoffteils 3 einer der Gruppen 4, 6, 8 identifiziert wird, wird die gesamte Gruppe 4, 6, 8 mit nicht gezeigten Aussortiermitteln aus dem Prozess aussortiert. Die als mangelfreie Gruppen identifizierten Gruppen werden in Pfeilrichtung 11 weiter geführt, beispielsweise zu einer Befüll- oder Verpackungsstation.

Wie im allgemeinen Beschreibungsteil erläutert ist es denkbar, die Prüfeinrichtung 10 nicht wie gezeigt inline mit der Vakuum-Beschichtungskammer 2 anzuordnen, sondern offline hierzu, wobei dann unter Beibehaltung des Gruppenbezugs ein Transport der beschichteten Kunststoffteile 3 zu der Prüfeinrichtung realisiert ist und dort eine Befüllung der Prüfeinrichtung über geeignete Handhabungsmittel mit mindestens einem, vorzugsweise ausschließlich einem Kunststoffteil 3 jeder Gruppe 4, 6, 8 erfolgt.

In Fig. 2 ist wie erläutert, eine beispielhafte Relativanordnung von Kunststoffteilen 3 einer Gruppe 4 auf einem Träger 5 gezeigt. Bevorzugt ist es nun, wenn von Beschichtungsvorgang zu Beschichtungsvorgang die Relativposition des für eine Prüfung auszuwählenden Kunststoffteils 3 variiert. So wird beispielsweise nach einem ersten Beschichtungsvorgang von dem ersten Träger 5 das auf Position B1 befindliche Kunststoffteil 3 auf Beschichtungsmängel überprüft und von dem ersten Träger 5 des nächsten Beschichtungsvorgangs ein anders relativpositioniertes Kunststoffteil 3, beispielsweise das auf Position B2 oder C3 positionierte Kunststoffteil 3.

In Fig. 3 sind zwei mittels eines Fourier-Transformations-Infrarotspektrometers aufgenommene Spektren gezeigt, und zwar zum einen eines mit einer Vakuum-Barriereschicht, hier beispielhaft einer SiOₓ beschichteten Kunststoffteils und eines unbeschichteten Kunststoffteils. Zu erkennen ist, dass die Absorption bei einer Wellenzahl von etwa 1070 bei der Kurve bzw. dem Spektrum des beschichteten Kunststoffteils 3 verglichen mit dem unbeschichteten Kunststoffteil sehr deutlich erkennbar ist.

In Fig. 1 ist weiter zu erkennen, dass oberhalb von jedem der Träger 5, 7, 9 mindestens eine eigene Plasmaquelle 12 für den Vakuum-Beschichtungsvorgang angeordnet ist.

### Bezugszeichen

- 1: Prüfsystem
- 2: Vakuum-Beschichtungskammer
- 3: Kunststoffteile
- 4: 1. Gruppe
- 5: 1. Träger
- 6: 2. Gruppe
- 7: 2. Träger
- 8: 3. Gruppe
- 9: 3. Träger
- 10: Prüfeinrichtung
- 11: Pfeilrichtung
- 12: Plasmaquelle

## Patentansprüche

1. Verfahren zum Prüfen eines Vakuum-Barriereschicht-Beschichtungsergebnisses von auf das Vorliegen systematischer Fehler nach einem Vakuum-Beschichtungsvorgang, bei welchem gleichzeitig eine Vielzahl von Kunststoffteilen (3), insbesondere Verpackungsbehälter, mit einer Vakuum-Barriereschicht, insbesondere umfassend SiOₓ, beschichtet werden, in dem mehrere Träger (5, 7, 9) mit jeweils einer mehrere der Kunststoffteile (3) umfassenden Gruppe (4, 6, 8) beladen und die, bevorzugt gleich großen, Gruppen (4, 6, 8) von Kunststoffteilen (3) gleichzeitig in einer Vakuum-Beschichtungskammer (2) mit der Vakuum-Barriereschicht im Vakuum, insbesondere mittels eines ALD-Beschichtungsverfahrens und/oder eines CVD-Beschichtungsverfahrens und/oder eines PVD-Beschichtungsverfahrens beschichtet werden,
**dadurch gekennzeichnet,**
**dass** nach dem Vakuum-Beschichtungsvorgang mindestens eines der Kunststoffteile (3), bevorzugt ausschließlich eines der Kunststoffteile (3), von jeder der Gruppen (4, 6, 8) der gleichzeitig in der Vakuum-Beschichtungskammer (2) beschichteten Kunststoffteile (3) in einer Prüfeinrichtung (10) zerstörungsfrei auf das Vorliegen von Beschichtungsmängeln überprüft wird.

2. Verfahren nach Anspruch 1,
**dadurch gekennzeichnet,**
**dass** bei Erkennen eines Beschichtungsfehlers bei einem überprüften Kunststoffteil (3) die gesamten Kunststoffteile (3) der zugehörigen Gruppe (4, 6, 8), bevorzugt vor einem der Prüfung nachgelagerten Verpackungsschritt, aussortiert werden.

3. Verfahren nach einem der Ansprüche 1 oder 2,
**dadurch gekennzeichnet,**
**dass** die Prüfeinrichtung (10) inline mit der Vakuum-Beschichtungskammer (2) angeordnet ist.

4. Verfahren nach einem der Ansprüche 1 oder 2,
**dadurch gekennzeichnet,**
**dass** die Prüfeinrichtung (10) offline bezogen auf die Vakuum-Beschichtungskammer (2) angeordnet ist und die Gruppen (4, 6, 8) von Kunststoffteilen (3) unter Beibehaltung des Gruppenbezugs, insbesondere verpackt, zu der Prüfeinrichtung (10) transportiert werden.

5. Verfahren nach einem der vorhergehenden Ansprüche,
**dadurch gekennzeichnet,**
**dass** nacheinander mehrere Vakuum-Beschichtungsvorgänge mit jeweils noch unbeschichteten Kunststoffteilen (3) in der Vakuum-Beschichtungskammer (2) durchgeführt werden, wobei die Kunststoffteile (3) bei jedem der Beschichtungsvorgänge in Gruppen (4, 6, 8) aufgeteilt auf mehreren Trägern (5, 7, 9) mit einer Vakuum-Barriereschicht beschichtet werden, wobei die Relativanordnung der Träger (5, 7, 9) in der Vakuum-Beschichtungskammer (2) und die, bevorzugt matrixartige, Relativanordnung der Kunststoffteile (3) jeder Gruppe (4, 6, 8) bei jedem Beschichtungsvorgang gleich bleibt, und dass bei der Überprüfung der Vakuum-Barriereschicht von Kunststoffspritzgussteilen von zwei aufeinanderfolgenden Beschichtungsvorgängen bei zwei einander bezüglich ihrer Relativposition entsprechenden Gruppen (4, 6, 8) die Vakuum-Barriereschicht von Kunststoffteilen (3) auf voneinander unterschiedlichen Relativpositionen innerhalb der jeweiligen Gruppe (4, 6, 8) überprüft wird.

6. Verfahren nach einem der vorhergehenden Ansprüche,
**dadurch gekennzeichnet,**
**dass** die Überprüfung der Vakuum-Barriereschicht in der Prüfeinrichtung (10) mittels eines spektralen Reflektionsverfahrens und/oder mittels optischer Kohärenztomografie und/oder mittels eines fourier-transformations-infrarotspektrometerischen Verfahrens durchgeführt wird.

7. Prüfsystem (1), ausgebildet zur Durchführung eines Verfahrens nach einem der vorhergehenden Ansprüche zum Prüfen eines Vakuum-Barriereschicht-Beschichtungsergebnisses auf das Vorliegen systematischer Fehler nach einem Vakuum-Beschichtungsvorgang, bei welchem gleichzeitig eine Vielzahl von Kunststoffteilen (3), insbesondere Verpackungsbehälter, mit einer Vakuum-Barriereschicht, insbesondere umfassend SiOₓ, beschichtet werden, in dem mehrere Träger (5, 7, 9) mit jeweils einer mehrere der Kunststoffteile (3) umfassenden Gruppe (4, 6, 8) beladbar und die, bevorzugt gleich großen, Gruppen (4, 6, 8) von Kunststoffteilen (3) gleichzeitig in einer Vakuum- Beschichtungskammer (2) mit der Vakuum-Barriereschicht im Vakuum, insbesondere mittels eines ALD-Beschichtungsverfahrens und/oder eines CVD-Beschichtungsverfahrens und/oder eines PVD-Verfahrens beschichtbar sind,
**dadurch gekennzeichnet,**
**dass** das Prüfsystem (1) eine zerstörungsfrei arbeitende Prüfeinrichtung (10) umfasst sowie Handhabungsmittel, die von einer Steuereinrichtung ansteuerbar sind, die die Handhabungsmittel derart ansteuernd ausgebildet ist, dass nach dem Vakuum-Beschichtungsvorgang mindestens eines der Kunststoffteile (3), bevorzugt ausschließlich eines der Kunststoffteile (3), von jeder der Gruppen (4, 6, 8) der gleichzeitig in der Vakuum-Beschichtungskammer (2) beschichteten Kunststoffteile (3) der Prüfeinrichtung (10) zugeordnet wird, und dass die Prüfeinrichtung (10) das jeweils zugeführte Kunststoffteil (3) zerstörungsfrei auf das Vorliegen von Beschichtungsmängeln überprüfend ausgebildet ist.

8. Prüfsystem nach Anspruch 7,
**dadurch gekennzeichnet,**
**dass** der Prüfeinrichtung (10) Aussortiermittel nachgeordnet sind, die bei Erkennen eines Beschichtungsfehlers bei einem überprüften Kunststoffteil (3) mittels der Prüfeinrichtung (10) die gesamten Kunststoffteile (3) der zugehörigen Gruppe (4, 6, 8), bevorzugt vor einem der Prüfung nachgelagerten Verpackungsschritt, aussortierend ausgebildet sind.

9. Prüfsystem nach einem der Ansprüche 7 oder 8,
**dadurch gekennzeichnet,**
**dass** die Prüfeinrichtung (10) der Vakuum-Beschichtungskammer (2) inline nachgeordnet ist.

10. Prüfsystem nach einem der Ansprüche 7 bis 9,
**dadurch gekennzeichnet,**
**dass** Prüfeinrichtung (10) die Vakuum-Barriereschicht auf Basis eines spektralen Reflektionsverfahrens und/oder mittels optischer Kohärenztomografie und/oder mittels eines fourier-transformationsinfrarotspektrometerischen Verfahrens überprüfend ausgebildet ist.
